Europäisches Patentamt

(19) European Patent Office (11) Publication number: **0 072 784**

Office européen des brevets **A2**

(12) **EUROPEAN PATENT APPLICATION**

(21) Application number: **82870044.3**

(22) Date of filing: **10.08.82**

(51) Int. Cl.³: **H 03 K 17/975**

(30) Priority: **19.08.81 US 294342**

(43) Date of publication of application:
**23.02.83 Bulletin 83/8**

(84) Designated Contracting States:
**BE DE FR GB IT**

(71) Applicant: **GENERAL INSTRUMENT CORPORATION**
**1775 Broadway**
**New York New York(US)**

(72) Inventor: **English, George P.**
**N.12475 Emerald Drive**
**Hayden Lake Idaho 83835(US)**

(72) Inventor: **Reisenauer, Mark E.**
**N. 3700 Meyer Road**
**Post Falls Idaho 83854(US)**

(74) Representative: **Vanderperre, Robert et al,**
**Bureau VANDER HAEGHEN 63 Avenue de la Toison d'Or**
**B-1060 Bruxelles(BE)**

(54) **Circuit board for use in capacitive keyboard.**

㊲ A capacitive keyboard circuit board (10) in which the capacitive plates (121, 131) are formed from separate conductive plates which are mounted onto the component side of the board. The plates are manufactured from thin metal and have mounting pins (133, 135) located perpendicular thereto. The mounting pins project through mounting holes (132, 134) in the circuit board and are soldered to traces (322, 324) on the conductor side of the circuit board. A completed keyboard assembly includes keyswitch actuators (61) mounted on the component side of the board in overlying relation to corresponding capacitive plates.

Fig.1

EP 0 072 784 A2

## Circuit board for use in capacitive keyboard

This invention relates generally to capacitive keyboards and more particularly to a circuit board having
conductive plates mounted thereto for use in a
capacitive keyboard.

In the past, various types of keyboards have been used
on computer terminals and the like for entering data
into a computer. The type of keyboards is generally
designated by the particular switching mechanism which
is used in its keyswitches. Mechanical switches
providing electrical contact between conductive
electrodes, reed switches utilizing a magnetic field to
close conductive electrodes, and Hall-effect switches
have all been used in past keyboard designs. Another
type of keyswitch used in keyboards is known as the
capacitive type. In such "capacitive keyboards", the
actuation of a keyswitch operates to change the
capacitance of two or more corresponding plates of a
capacitor. Each separate keyswitch has its own set of
plates. The capacitor plates are usually located on the
surface of a printed circuit board, the plates being
formed during the conventional etching process used
in the manufacture of such boards.

Conventional printed circuit boards are manufactured
from a base material comprising a non-conductive
substrate and a copper layer coated with a photosensitive
material known as a "photoresist". The copper side of
the board is photographically exposed to a negative of
the pattern which is to be placed on the finished circuit board.

The pattern contains areas where copper is to remain on the finished product and other areas where copper is to be removed from the printed circuit board. During the exposure process, light which is transmitted through the negative hardens the chemical photoresist layer. In areas where no light is transmitted, the resist layer is not hardened. After exposure, the circuit board is placed into an etching solution which removes the copper layer from the areas which were not exposed to light during the exposure process. The remaining circuit board contains conductive copper traces only in the desired areas. Holes may be drilled into the remaining traces and through the circuit board at desired locations. Electronic components may then be mounted to the non-copper side of the circuit board with their leads inserted into the holes and being soldered to corresponding copper traces.

In past capacitive keyboards, the capacitive plates were formed from copper areas which were left on the copper side of the printed circuit board. As a result, the copper areas forming the capacitive plates were interspersed on the same side of the circuit board with the copper traces forming the conductors for the associated electronic circuitry. This design caused several problems. One problem was that the amount of area on the printed circuit board available for circuit conductors was substantially reduced due to the space requirements for the capacitive plates. The number of conductors on a given area of circuit board is known as "trace density". By using up space that would otherwise be available for conductive traces, the presence of such capacitive plates adversely affected the trace density of prior art circuit boards.

Another problem which exists in prior art boards results from the necessity of soldering electronic component leads to the conductive traces. In assembling components to circuit boards, a process known as "wave" or "flow" soldering is used. In this procedure, the leads of all of the components to be assembled to the circuit board are inserted into corresponding holes in the circuit board from the non-copper side. After all the components have been inserted, a wave of solder is caused to flow across the copper side of the board. The solder coats the copper and the leads, permanently soldering the leads into place. For proper operation of the capacitive keyswitch, however, it is essential that the copper areas forming the capacitive plates remain solder free. To accomplish this, a temporary solder mask must be applied to the capacitive plates. The solder mask prevents solder from adhering to the capacitive plates and must be cleaned off of the capacitive plates after the flow solder process.

A third problem which occurs with prior art capacitive keyboards relates to the placement of electronic components on the circuit board. In capacitive keyboards, the actuation of a key by a keyboard operator causes the base of a plunger connected to the key to come into close proximity to the capacitive plates. The side of the circuit board containing the capacitive plates must therefore face upward, toward the operator and the keyboard keys. In prior art circuit boards having the capacitive plates on the same side of the board as the conductive traces, the conductive traces also face upward. The electronic components mounted to the non-copper side of the board therefore face downwardly and are more susceptible to damage than they would be if they were mounted on top of the board.

Another problem with prior art single sided keyboard circuit boards is that they require jumpers to complete electrical circuits. The needs for such jumpers increases the manufacturing cost of the circuit boards.

It would be advantageous to provide a capacitive keyboard that provides for improved trace density of the circuitry on the copper side of its circuit board. Such a keyboard should utilize a circuit board which eliminates the need to protect the capacitive plates from becoming coated with solder during the flow soldering process. The circuit board should also enable the electronic components mounted thereon to be placed on the same side of the board which contains the capacitive plates. Additionally, it would be beneficial if such a circuit board reduced the need for separate wire jumpers.

This invention relates to such a keyboard.

The capacitive keyboard of the present invention utilizes a printed circuit board having first and second sides. The circuit board contains a plurality of holes which are drilled therethrough and into which electronic components and the like can be mounted. One side of the circuit board contains a plurality of electrically conductive traces. The other side of the circuit board has at least one pair of thin conductive plates mounted thereto and parallel therewith. Each plate has at least one terminal protruding therefrom which extends into one of the holes in the circuit board to connect with a corresponding trace on the other side of the circuit board. Actuating means are mounted in overlaying relation to the pair of conductive plates. When actuated, the actuating means causes the electrical capacitance between the plates to change

The above described configuration is advantageous in that the conductive plates are not present on the same side of the printed circuit board as the conductive traces forming the circuit.  Thus, the problems of trace density, flow soldering, electronic component placement, and wire jumpers are reduced.

Exemplary embodiments of the invention are described in detail hereinafter  with reference to the appended drawings, in which :

Figure 1 is a perspective view showing a completed keyboard in accordance with the present invention;

Figure 2 is an exploded view of a key switch and circuit board in accordance with one embodiment of the present invention;

Figure 3 is a perspective view showing the reverse side of the circuit board shown in Figure 2;

Figure 4 is a detailed view of a keyswitch taken substantially along the plane indicated by line 4-4 of Figure 2;

Figure 5 is an exploded view of a key switch and circuit board in accordance with another embodiment of the present invention;

Figure 6 is a perspective view showing the reverse side of the circuit board shown in Figure 5;

Figure 7 is a detailed view of a keyswitch taken substantially along the plane indicated by line 7-7 of Figure 5.

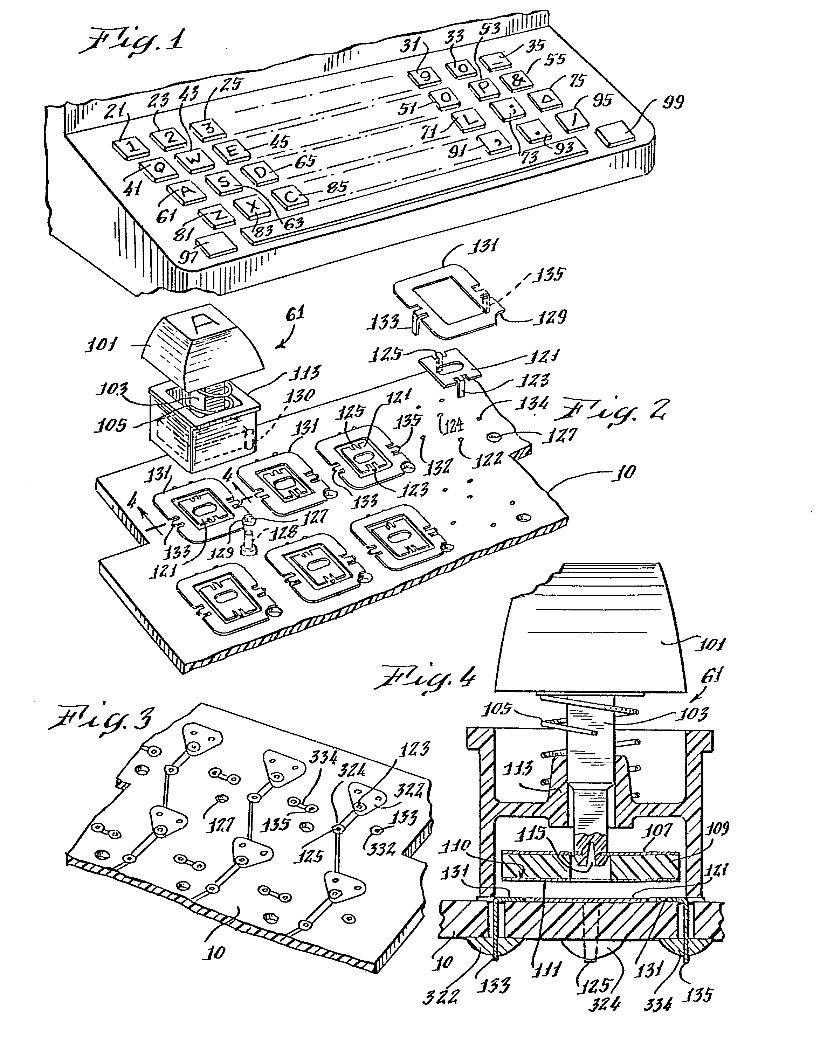

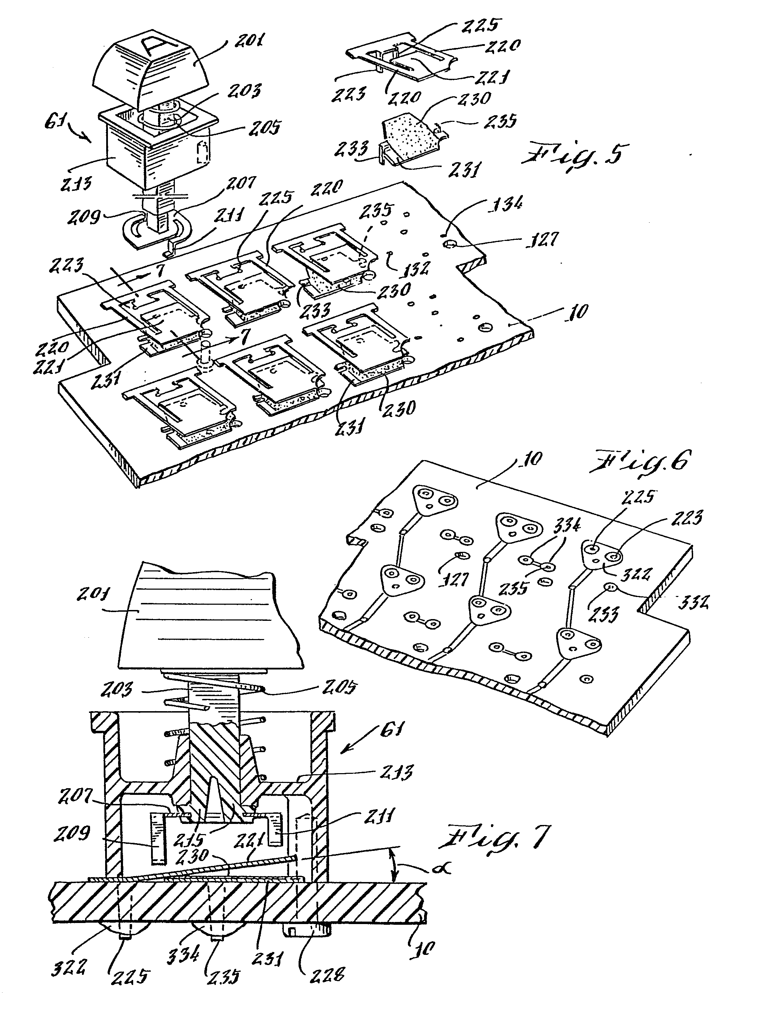

As shown in Figure 1, the present invention relates to capacitive keyboards of the type having a circuit board 10 (shown in Fig. 2) on which keyswitches 21 through 99 are mounted. Such keyboards are used for the entry of data in various computer oriented applications.

As shown in Figure 2, a typical keyswitch 61 comprises a key top 101 which is affixed to a plunger 103. A spring 105 provides a return force to the plunger after the key top 101 has been momentarily depressed. Return spring 105 sits on housing 113, providing a spring force directed away therefrom. Housing 113 encloses an actuator assembly which serves to change the capacitance of two series capacitors formed by capacitive plates 121 and 131 as described below.

In the embodiment of Figures 2 through 4, the actuator assembly comprises a metal plate 107 which is affixed to plunger 103. One way to affix metal plate 107 to plunger 103 is to use resilient tabs 115 onto which metal plate 107 can be snapped. A foam pad 109 is affixed to metal plate 107 with a suitable adhesive. The actuator assembly is completed by mounting a mylar sheet 111 to the outer surface of foam pad 109. Mylar sheet 111 is metalized on one side, the metalized layer 110 being adjacent foam pad 109. Thus, the surface of mylar facing capacitive plates 121 and 131 is non-conductive.

Key switch 61 is mounted to circuit board 10 by screw 128 which protrudes through a mounting hole 127 in the circuit board and into threaded mounting hole 130 in switch housing 113. Notch 129 is provided in capacitive plate 131 to allow screw 128 to pass thereby without interference. Those skilled in the art will appreciate that any other of a variety of mounting schemes can alternatively be used.

Turning now to the circuit board 10 itself, Figure 2 shows an exploded view of the mounting of capacitive plates 121 and 131 thereon. Capacitive plate 121 has tabs 123 and 125 which protrude through corresponding holes 122 and 124 in circuit board 10. Plate 121 is mounted to circuit board 10 by soldering tabs 123 and 125 to respective circuit traces on the opposite of circuit board 10. As shown in Figure 3, pin 123 of plate 121 corresponds with circuit trace 322 on the other side of the circuit board. Similarly, pin 125 corresponds to circuit trace 324. Pins 123 and 125 can be soldered to traces 322 and 324 in a conventional flow soldering process which occurs after all of the capacitive plates and associated electronic components are mounted onto the component side of circuit board 10.

Outer capacitive plate 131 contains pins 133 and 135 which correspond with holes 132 and 134 in circuit board 10. These pins are also soldered to corresponding traces 332 and 334 on the opposite side of circuit board 10.

Capacitive plates 121 and 131 are formed from a conductive metal or metal alloy. One alloy that can be used for these plates contains copper and nickel and is known in the trade as CDA alloy #725. Those skilled in the art will appreciate that other metals and/or alloys may be used with equally goods results. The capaoitive plates may be formed in any number of ways. One way is to chemically etch the plates in strips from the base metal material. After etching, the mounting pins are bent into shape and each individual plate is severed from the strip of plates and

- 8 -

0072784

mounted into the circuit board. The use of the chemical etching process gives nicely rounded edges which facilitates the machine handling of the strips of plates in the automated assembly of circuit boards.

In the embodiment shown, the capacitive plates 121, 131 comprise an outer plate 131 of generally square shape having a generally square opening in the center thereof and an inner plate 121 of generally square shape within the perimeter of the opening in the outer plate. However, other shapes, such as semi-circles or rectangular strips may alternatively be used.

In operation, the pair of conductive plates 121, 131 serves, in conjunction with the metalized mylar sheet 111 on the actuator assembly, to form a pair of series connected capacitors. The metalized mylar sheet 111 which is present on the actuator assembly is common to both of the separate capacitors and serves as the series interconnect therebetween. Depressing a key on the keyboard brings the metalized mylar sheet 111 into close proximity to the pair of plates 121, 131 on the circuit board 10. This alters the capacitance of the series capacitors. Thus, it is possible to determine whether or not a key has been pressed by placing a voltage transition across the pair of plates 121, 131 on the circuit board 10 and measuring the resultant current pulse therethrough. If the keyswitch has been actuated, the current measurement will indicate one value of capacitance. If the keyswitch has not been actuated, another value of current will be detected.

Another embodiment of the present invention is shown in Figures 5 through 7. Like the embodiment shown in Figures 2 through 4, key switch 61 comprises a key top 201 mounted to a plunger 203. Spring 205 provides the return force after key top 201 has been momentarily depressed. Spring 205 acts against housing 213. Housing 213 contains the key switch actuator assembly which comprises a metal disc 207 that has been snapped onto resilient locking tabs 215. Actuator disc 207 contains fingers 209 and 211 which extend therefrom in spring loaded relation thereto. Fingers 209 and 211 act against capacitive plate 221 to provide a downward force thereto when key top 201 is depressed.

Capacitive plate 221 extends, in its non-depressed condition, upwardly at an angle α from circuit board 10 to which it is mounted by pins 223 and 225. Plate 221 exerts a spring force upward from circuit board 10 which is determined by the metal material forming the plate along with the geometry of lever arms 220.

In the configuration shown in Figure 5, a second capacitive plate 231 is mounted to circuit board 10 by pins 233 and 235. A non-conductive coating 230 is applied to capacitive plate 231 to electrically insulate it from capacitive plate 221 when the plate are pressed together. Coating 230 may be any insulating material, such as a plastic based paint which can be easily applied to the surface of plate 231. In operation, depressing a key on the keyboard brings capacitive plate 221 into close proximity with capacitive plate 231. This alters the capacitance between capacitive plates 221, 231. The design of the actuator assembly shown in the capacitive keyswitch of Figures 5 and 7 provides a "linear feel" to the keyboard operator such that the amount of force required to actuate the keyswitch is contant throughout the downward travel of the key top. The linear feel is advantageous in that it provides a highly marketable keyboard.

The connections of capacitive plate mounting pins 223, 225, 233 and 235 to circuit traces on the other side of circuit board 10 is shown in Figure 6.

The electrical operation of the keyboard illustrated in Figure 5 is similar to that of Figure 2. In both configurations, a capacitor is formed from the conductive plates mounted on circuit board 10. In the embodiment of Figure 5 only one capacitor exists; namely, that formed from capacitive plates 221 and 231 which have dielectric coating 230 therebetween. In the embodiment shown in Figure 2, two separate capacitors are formed which are connected in series. In that embodiment, capacitive pads 121 and 131 are coupled in series relation by metalized mylar sheet 111 which forms a third capacitive plate. Thus, one of the series capacitors in the embodiment of Figure 2 comprises inner capacitive plate 121 in parallel relation with metalized layer 110 having dielectric mylar 111 therebetween. The second series capacitor is formed from outer capacitive plate 131 in generally parallel relation to metalized layer 110 having dielectric mylar 111 therebetween.

In operation of a keyboard in accordance with the present invention, a change of capacitance will result between the capacitive plates of a given keyswitch when that keyswitch is actuated. Thus, if keyswitch 61 is actuated in Figure 2, the change of capacitance will arise between inner and outer capacitive plates 121 and 131. This change may be detected by causing a voltage transition to occur across capacitive plates 121 and 131 and measuring the resulting current pulse therethrough. If the keyswitch is in the actuated position when the voltage transition occurs, one value of current will be measured. If the keyswitch is in the non-actuated position, another current value will be measured. In the embodiment shown in Figure 5, the voltage transition will be developed across capacitive plates 221 and 231 and the current therethrough will be measured. It is noted that in a keyboard constructed in accordance with the present invention, no electrical connection is required to be made to the keyswitch actuator itself. Actuation of the keyswitch causes a change in capacitance across conductive plates which are mounted to a fixed circuit board.

While the invention has been described in connection with preferred embodiments, it is not intended to limit the scope of the invention to the particular forms set forth, but, on the contrary, it is intended to cover such alternatives, modifications and equivalents as may be included within the spirit and scope of the invention as defined by the appended claims.

CLAIMS

1. A capacitive keyboard , characterized by a circuit board (10) having first and second sides and a plurality of holes therethrough (132, 134) into which electronic components and the like can be mounted; a plurality of electrically conductive traces (322, 324) situated on the first side of said circuit board; at least one pair of conductive plates (121, 131; 221, 231) mounted to the second side of said circuit board, each plate having at least one terminal (133, 135; 233, 235) protruding therefrom extending into one of said holes to electrically connect with a corresponding trace on the first side of said circuit board; and means (111) mounted in overlaying relation to said pair of plates to cause the electrical capacitance between said plates to change upon actuation of said means.

2. The keyboard of claim 1, wherein said terminals (133, 135) are soldered to corresponding traces (322, 324) to attach said plates to said circuit board.

3. The keyboard of claim 1 or 2, wherein said pair of plates comprises an outer plate (131) of generally square shape having a generally square opening in the center thereof, and an inner plate (121) of generally square shape within the perimeter of said opening.

4. The keyboard of claim 1 or 2, wherein said pair of plates comprises a movable top plate (221) hingedly overlying a fixed bottom plate (231) and further comprising dielectric means (230) interposed between said top and bottom plates.

5. A circuit board for use in a capacitive keyboard, characterized by first and second opposite sides; a plurality of conductive traces (322, 324) on the first side thereof, said traces including component mounting portions having holes (132, 134) therein which extend through said circuit board to the second side thereof; at least one pair of conductive plates (121, 131; 221, 231) mounted on said second side, each plate having at least one terminal (133, 135; 233, 235) protruding therefrom, said plates being mounted with said terminals extending through corresponding ones of said holes.

6. The circuit board of claim 5, wherein said terminals are soldered to corresponding mounting portions of said traces (322, 324) to attach said plates to said circuit board.

7. The circuit board of claim 5 or 6, wherein said pair of plates comprises an outer plate (131) of generally square shape having a generally square opening in the center thereof, and an inner plate (121) of generally square shape situated within the perimeter of said opening.

8. The circuit board of claim 5 or 6, wherein said pair of plates comprises a movable top plate (221) hingedly overlying a fixed bottom plate (231) and further comprising dielectric means (230) interposed between said top and bottom plates.

9. The circuit board of claim 5, further characterized by means (213) for mounting a keyswitch actuator to said second side in overlaying relation to said pair of plates.

Fig.1

Fig.2

Fig.3

Fig.4

Fig.5

Fig.6

Fig.7